# EUROPEAN PATENT APPLICATION

(11) **EP 3 993 255 A1**
(43) Date of publication of application: **04.05.2022**
(21) Application number: 20830988.0
(22) Date of filing: 17.06.2020
(51) Int. Cl.: H02N 11/00, H01L 35/32

(54) **THERMOELECTRIC GENERATION DEVICE**

(30) Priority: 26.06.2019 JP 2019119040
(71) Applicant: Sanoh Industrial Co., Ltd., Shibuya-ku Tokyo 150-0002 (JP)
(72) Inventor: MEI, Biao, Koga-shi, Ibaraki 306-0041 (JP); GOTO, Naoya, Koga-shi, Ibaraki 306-0041 (JP)
(74) Representative: Grünecker Patent- und Rechtsanwälte PartG mbB
(86) International application number: PCT/JP2020/023772
(87) International publication number: WO 2020/262149

(57) **Abstract**

A thermoelectric generation device according to an aspect of the present disclosure includes a first thermoelectric generation module, a second thermoelectric generation module, and an electroconductive member electrically connecting the first and second thermoelectric generation modules. The first thermoelectric generation module is spaced from the second thermoelectric generation module. The first and second thermoelectric generation modules each have at least one heat utilization power generation element that includes a stack of an electrolyte layer and a thermoelectric conversion layer and a housing that accommodates the heat utilization power generation element.

## Description

### Technical Field

The present disclosure relates to a thermoelectric generation device.

### Background Art

As elements that convert thermal energy into electrical energy, heat utilization power generation elements obtained by combining an electrolyte and a thermoelectric conversion material that generates thermally excited electrons and holes are known (see Patent Literature 1). According to a power generation system using the heat utilization power generation elements, it is possible to generate power simply by raising a temperature of the entire system without causing a temperature difference in the system.

### Citation List

### Patent Literature

[Patent Literature 1] PCT International Publication No. 2017/038988

### Summary of Invention

### Technical Problem

According to a study by the present inventors, in order to realize high output of a power generation system using the elements described in Patent Literature 1, it is necessary to solve a problem that a rate of heat supply to the power generation system is limited. That is, even though the power generation system has a potential to generate high-voltage and/or high-current electricity, the potential can only be sufficiently exhibited when heat is supplied to the heat utilization power generation elements included in the power generation system as evenly as possible.

An aspect of the present disclosure provides a thermoelectric generation device that can sufficiently prevent a rate of heat supply from being limited and is useful for achieving high output.

### Solution to Problem

A thermoelectric generation device according to an aspect of the present disclosure includes a first thermoelectric generation module, a second thermoelectric generation module, and an electroconductive member electrically connecting the first and second thermoelectric generation modules. The first thermoelectric generation module is spaced from the second thermoelectric generation module. The first thermoelectric generation module has at least one heat utilization power generation element that includes an electrolyte layer and a thermoelectric conversion layer and a first housing that accommodates the heat utilization power generation element. The second thermoelectric generation module has at least one heat utilization power generation element that includes an electrolyte layer and a thermoelectric conversion layer and a second housing that accommodates the heat utilization power generation element.

Since the first thermoelectric generation module is spaced from the second thermoelectric generation module, for example, a flow path is defined by an outer surface of the first housing and an outer surface of the second housing. By allowing a thermal fluid (for example, a high-temperature gas or liquid) to flow through the flow path, it is possible to efficiently supply heat to the first and second thermoelectric generation modules. The flow path may extend along a main surface of the thermoelectric generation module or may extend along a side surface of the thermoelectric generation module.

The first and second thermoelectric generation modules may be electrically connected in parallel or may be electrically connected in series. By connecting a plurality of thermoelectric generation modules in series, it is possible to increase an electromotive force of the thermoelectric generation device. On the other hand, by connecting a plurality of thermoelectric generation modules in parallel, it is possible to increase an output current of the thermoelectric generation device.

From a viewpoint of increasing the electromotive force and/or the output current, the first and second thermoelectric generation modules may each have a plurality of the heat utilization power generation elements. The plurality of heat utilization power generation elements may be stacked to be electrically connected in series or may be stacked to be electrically connected in parallel. In a case in which the plurality of heat utilization power generation elements are electrically connected in series, from a viewpoint of further increasing the electromotive force, an electron transmission layer may be provided between the adjacent heat utilization power generation elements. In a case in which the plurality of heat utilization power generation elements are electrically connected in parallel, a collecting electrode electrically connected to the electroconductive member and an insulating layer may be provided between the adjacent heat utilization power generation elements.

### Advantageous Effects of Invention

According to the aspect of the present disclosure, a thermoelectric generation device that can sufficiently prevent a rate of heat supply from being limited and is useful for achieving high output is provided.

### Brief Description of Drawings

FIG. 1 is a cross-sectional view schematically showing a first embodiment of a thermoelectric generation device according to the present disclosure.
FIG. 2 is a cross-sectional view schematically showing a modification example of the thermoelectric generation device according to the first embodiment.
FIG. 3 is a cross-sectional view schematically showing a second embodiment of a thermoelectric generation device according to the present disclosure.
FIG. 4 is a cross-sectional view schematically showing thermoelectric generation modules included in the thermoelectric generation device shown in FIG. 3.
FIG. 5 is a cross-sectional view schematically showing a modification example of the thermoelectric generation device according to the second embodiment.

### Description of Embodiments

Hereinafter, embodiments of the present disclosure will be described in detail with reference to the accompanying drawings. In the following description, the same reference signs will be used for the same elements or elements having the same function and duplicate description will be omitted.

### <First embodiment>

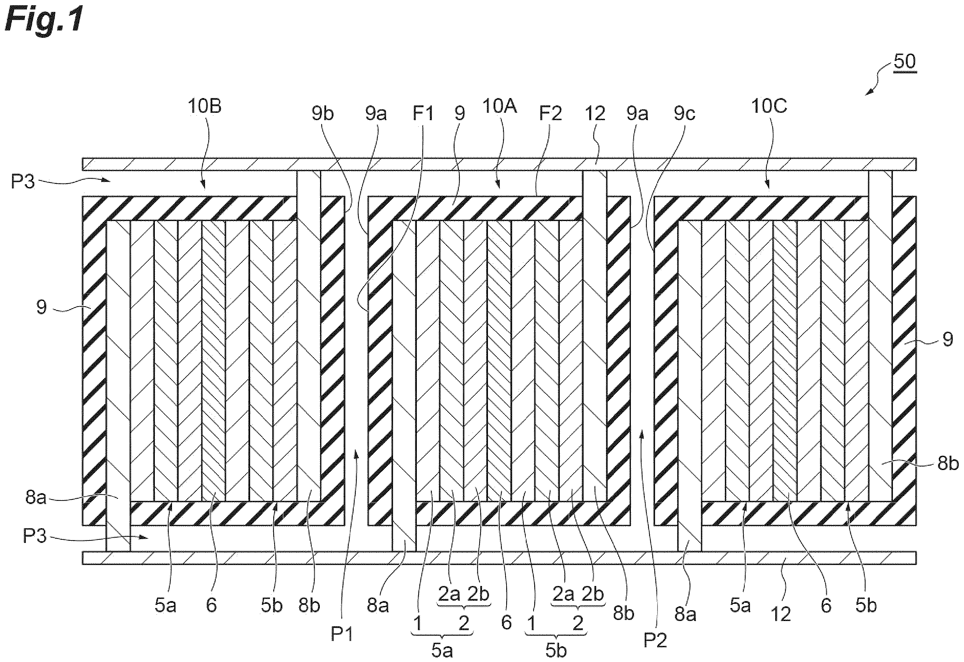

FIG. 1 is a cross-sectional view schematically showing a thermoelectric generation device according to the present embodiment. A thermoelectric generation device 50 shown in FIG. 1 includes three thermoelectric generation modules 10A, 10B, and 10C, which are electrically connected in parallel through an external collector 12 (an electroconductive member). The thermoelectric generation module 10A is disposed between two thermoelectric generation modules 10B and 10C and is spaced from the thermoelectric generation modules 10B and 10C. The external collector 12 is also spaced from the thermoelectric generation modules 10A, 10B, and 10C. Hereinafter, a configuration of the thermoelectric generation module 10A will be described. In the present embodiment, a configuration of each of the thermoelectric generation modules 10B and 10C is the same as that of the thermoelectric generation modules 10A, and thus description thereof will be omitted.

The thermoelectric generation module 10A has two heat utilization power generation elements 5a and 5b, an electron transmission layer 6, a pair of collecting electrodes 8a and 8b, and a housing 9 for accommodating them. A shape of the thermoelectric generation module 10A in a plan view is a polygonal shape such as a rectangular shape and may be a circular shape or an elliptical shape. The two heat utilization power generation elements 5a and 5b are stacked to be electrically connected in series. The heat utilization power generation elements 5a and 5b generate thermally excited electrons and holes using heat supplied from the outside. The generation of thermally excited electrons and holes by the heat utilization power generation elements 5a and 5b occurs, for example, at 25 °C or higher and 300 °C or lower. From a viewpoint of generating a sufficient number of thermally excited electrons and holes, the heat utilization power generation elements 5a and 5b may be heated to, for example, 50 °C or higher. From a viewpoint of satisfactorily preventing deterioration of the heat utilization power generation elements 5a and 5b, an upper limit of a heating temperature of each of the heat utilization power generation elements 5a and 5b is, for example, 200 °C. A temperature at which a sufficient number of thermally excited electrons are generated is, for example, a temperature at which density of the thermally excited electrons of each of the heat utilization power generation elements 5a and 5b is 10¹⁵/cm³ or more.

The heat utilization power generation element 5a has a stacked structure including an electrolyte layer 1, an electron thermal excitation layer 2a, and an electron transport layer 2b in that order. A thermoelectric conversion layer 2 is constituted by the electron thermal excitation layer 2a and the electron transport layer 2b. In the present embodiment, a configuration of the heat utilization power generation element 5b is the same as that of the heat utilization power generation element 5a, and thus description thereof will be omitted.

The electrolyte layer 1 is a layer containing a solid electrolyte in which a charge transport ion pair can move under the above temperature conditions. As the charge transport ion pair moves in the electrolyte layer 1, a current flows in the electrolyte layer 1. The "charge transport ion pair" is a stable pair of ions with different valences. When one ion is oxidized or reduced, it becomes the other ion and can move electrons and holes. An oxidation-reduction potential of the charge transport ion pair in the electrolyte layer 1 is lower than a valence band potential of a thermoelectric conversion material contained in the electron thermal excitation layer 2a. Therefore, at an interface between the electron thermal excitation layer 2a and the electrolyte layer 1, an easily oxidizable ion of the charge transport ion pairs is oxidized and becomes the other ion. The electrolyte layer 1 may contain ions other than the charge transport ion pair. The electrolyte layer 1 can be formed by, for example, a squeegee method, a screen printing method, a sputtering method, a vacuum vapor deposition method, a CVD method, a sol-gel method, or a spin coating method. A thickness of the electrolyte layer 1 is, for example, 0.1 µm or more and 100 µm or less. The electrolyte layer 1 may be a hole transport semiconductor.

The solid electrolyte contained in the electrolyte layer 1 is, for example, a substance that is physically and chemically stable at the above temperatures and contains a polyvalent ion. The solid electrolyte is, for example, a sodium ion conductor, a copper ion conductor, an iron ion conductor, a lithium ion conductor, a silver ion conductor, a hydrogen ion conductor, a strontium ion conductor, an aluminum ion conductor, a fluorine ion conductor, a chlorine ion conductor, an oxide ion conductor, or the like. The solid electrolyte may be, for example, polyethylene glycol (PEG) having a molecular weight of 600,000 or less or a derivative thereof. In a case in which the solid electrolyte is PEG, for example, a polyvalent ion source such as a copper ion or an iron ion may be contained in the electrolyte layer 1. From a viewpoint of improving a life span, an alkali metal ion may be contained in the electrolyte layer 1. The molecular weight of PEG corresponds to a weight-average molecular weight measured by gel permeation chromatography in terms of polystyrene. The electrolyte layer 1 may contain materials other than the solid electrolyte. For example, the electrolyte layer 1 may contain a binder for binding the solid electrolyte, a sintering aid for assisting formation of the solid electrolyte, or the like.

The electron thermal excitation layer 2a is a layer that generates thermally excited electrons and holes and is in contact with the electrolyte layer 1. The electron thermal excitation layer 2a contains a thermoelectric conversion material. The thermoelectric conversion material is a material in which excited electrons increase in a high temperature environment and is a semiconductor material such as a metal semiconductor (Si, Ge), a tellurium compound semiconductor, a silicon-germanium (Si-Ge) compound semiconductor, a silicide compound semiconductor, a skutterudite compound semiconductor, a clathrate compound semiconductor, a Heusler compound semiconductor, a half-Heusler compound semiconductor, a metal oxide semiconductor, or an organic semiconductor. From a viewpoint of generating sufficient thermally excited electrons at a relatively low temperature, the thermoelectric conversion material may be germanium (Ge). The electron thermal excitation layer 2a may contain a plurality of thermoelectric conversion materials. The electron thermal excitation layer 2a may contain materials other than the thermoelectric conversion material. For example, the electron thermal excitation layer 2a may contain a binder for binding the thermoelectric conversion material, a sintering aid for assisting formation of the thermoelectric conversion material, or the like. The electron thermal excitation layer 2a is formed by, for example, a squeegee method, a screen printing method, a discharge plasma sintering method, a compression forming method, a sputtering method, a vacuum vapor deposition method, a chemical vapor deposition method (a CVD method), a spin coating method, or the like. A thickness of the electron thermal excitation layer 2a is, for example, 0.1 µm or more and 100 µm or less.

The electron transport layer 2b is a layer that transports the thermally excited electrons generated in the electron thermal excitation layer 2a to the outside and is located on a side opposite to the electrolyte layer 1 via the electron thermal excitation layer 2a in a stacking direction. The electron transport layer 2b contains an electron transport material. The electron transport material is a material of which a conduction band potential is the same as or higher than a conduction band potential of the thermoelectric conversion material. A difference between the conduction band potential of the electron transport material and the conduction band potential of the thermoelectric conversion material is, for example, 0.01 V or more and 0.1 V or less. The electron transport material is, for example, a semiconductor material, an electron transport organic substance, or the like. The electron transport layer 2b is formed by, for example, a squeegee method, a screen printing method, a discharge plasma sintering method, a compression forming method, a sputtering method, a vacuum vapor deposition method, a CVD method, a spin coating method, or the like. A thickness of the electron transport layer 2b is, for example, 0.1 µm or more and 100 µm or less.

The semiconductor material used for the electron transport material is, for example, the same as the semiconductor material contained in the electron thermal excitation layer 2a. The electron transport organic substance is, for example, an N-type electroconductive polymer, an N-type low-molecular-weight organic semiconductor, a π-electron conjugated compound, or the like. The electron transport layer 2b may contain a plurality of electron transport materials. The electron transport layer 2b may contain materials other than the electron transport material. For example, the electron transport layer 2b may contain a binder for binding the electron transport material, a sintering aid for assisting formation of the electron transport material, or the like. From a viewpoint of electron transportability, the semiconductor material may be n-type Si. The electron transport layer 2b containing n-type Si is formed, for example, by doping a silicon layer with phosphorus or the like.

The electron transmission layer 6 is a layer for conducting electrons moving in the thermoelectric generation module 10A only in a predetermined direction. The electron transmission layer 6 is a layer that exhibits electron conductivity and does not exhibit ionic conductivity. Therefore, the electron transmission layer 6 can be called an ion conduction prevention layer. The electron transmission layer 6 is interposed between the electron transport layer 2b of the heat utilization power generation element 5a and the electrolyte layer 1 of the heat utilization power generation element 5b. The heat utilization power generation elements 5a and 5b are connected in series with each other via the electron transmission layer 6.

The electron transmission layer 6 is formed by, for example, a squeegee method, a screen printing method, a discharge plasma sintering method, a compression forming method, a sputtering method, a vacuum vapor deposition method, a CVD method, a spin coating method, a plating method, or the like. In a case in which the electrolyte layer 1 is an organic electrolyte layer, the electron transmission layer 6 may be provided, for example, on a surface of the electron transport layer 2b of the heat utilization power generation element 5a. On the other hand, in a case in which the electrolyte layer 1 is an inorganic electrolyte layer, the electron transmission layer 6 may be provided, for example, on a surface of the electrolyte layer 1 of the heat utilization power generation element 5b. A thickness of the electron transmission layer 6 is, for example, 0.1 µm or more and 100 µm or less.

A work function of the electron transmission layer 6 is larger than a work function of the electron transport layer 2b. In other words, a band gap of the electron transmission layer 6 is larger than a band gap of the electron transport layer 2b. A difference between the work function or band gap of the electron transmission layer 6 and the band gap of the electron transport layer 2b is, for example, 0.1 eV or more. Further, a valence band potential of the electron transmission layer 6 may be higher than a reduction potential of the ions in the electrolyte layer 1. In this case, an oxidation reaction of the ions is unlikely to occur at an interface between the electron transmission layer 6 and the electrolyte layer 1. For example, in a case in which the electrolyte layer 1 is an organic electrolyte layer, the electron transmission layer 6 contains indium tin oxide (ITO), fluorine-doped tin oxide (FTO), an electron transmission polymer material, or the like. Further, for example, when the electrolyte layer 1 is an inorganic electrolyte layer, the electron transmission layer 6 contains platinum (Pt), gold (Au), silver (Ag), an aluminum alloy (for example, duralumin or a Si-Al alloy), an electron transmission polymer material, or the like. The electron transmission polymer material is, for example, PEDOT/PSS. A conduction band potential of the electron transmission layer 6 may be lower than a conduction band potential of the electron transport layer 2b. In this case, electrons easily move from the electron transport layer 2b to the electron transmission layer 6.

The collecting electrode 8a is a positive electrode of the thermoelectric generation module 10A and is located at one end of the thermoelectric generation module 10A in the stacking direction. The collecting electrode 8b is a negative electrode of the thermoelectric generation module 10A and is located at the other end of the thermoelectric generation module 10A in the stacking direction. Each of the collecting electrodes 8a and 8b is, for example, an electroconductive plate having a single-layer structure or a stacked structure. The electroconductive plate is, for example, a metal plate, an alloy plate, or a composite plate of a metal plate and an alloy plate. From a viewpoint of satisfactorily exhibiting performance of the thermoelectric generation module 10A, at least one of the collecting electrodes 8a and 8b may exhibit high thermal conductivity. For example, the thermal conductivity of at least one of the collecting electrodes 8a and 8b may be 10 W/m·K or more. Since no temperature difference is required in the thermoelectric generation module 10A, it is desirable that both the collecting electrodes 8a and 8b exhibit high thermal conductivity.

The housing 9 accommodates the heat utilization power generation elements 5a and 5b or the like. The housing 9 is made of, for example, a material having excellent heat transfer properties and insulation properties. Due to the high heat transfer properties of the housing 9, heat is efficiently supplied to the heat utilization power generation elements 5a and 5b from the outside. Examples of a material of the housing 9 include a resin containing Si (a Si heat transfer resin), ceramics, and high thermal conductive glass. In order to achieve more excellent heat transfer properties of the housing 9 while maintaining the insulating properties thereof, the housing 9 may be formed of one material having insulation properties and another material (for example, a metal) having heat transfer properties embedded inside the one material.

As described above, the thermoelectric generation module 10A is disposed between the two thermoelectric generation modules 10B and 10C and is spaced from the thermoelectric generation modules 10B and 10C. Since the thermoelectric generation modules 10A, 10B, and 10C are disposed to be spaced from each other, it is possible to form flow paths P1 and P2 between the adjacent thermoelectric generation modules. The flow path P1 is defined by an outer surface 9a of the housing 9 of the thermoelectric generation module 10A and an outer surface 9b of the housing 9 of the thermoelectric generation module 10B. The flow path P2 is defined by an outer surface 9a of the housing 9 of the thermoelectric generation module 10A and an outer surface 9c of the housing 9 of the thermoelectric generation module 10C. Further, a flow path P3 is also formed between the thermoelectric generation modules 10A, 10B, and 10C and the external collector 12. The flow paths P1 and P2 extend along a main surface F1 of the thermoelectric generation modules 10A, 10B, and 10C. On the other hand, the flow path P3 extends along a side surface F2 of the thermoelectric generation modules 10A, 10B, and 10C.

By allowing a thermal fluid (for example, a high-temperature gas or liquid) to flow through the flow paths P1, P2, and P3, it is possible to efficiently supply heat to the thermoelectric generation modules 10A, 10B, and 10C. The thermoelectric generation device 50 can efficiently generate high-voltage and/or high-current electricity when applied to a system in which a thermal fluid flows (for example, a heat exchanger, a heat pump, or a cooling pipe). The thermoelectric generation module 10A may have a relatively large scale because a rate of heat supply is unlikely to be limited. A power generation output of the thermoelectric generation module 10A according to the present embodiment may be, for example, 1000 kWh or more, 10 to 1000 kWh, or 0.1 to 10 kWh.

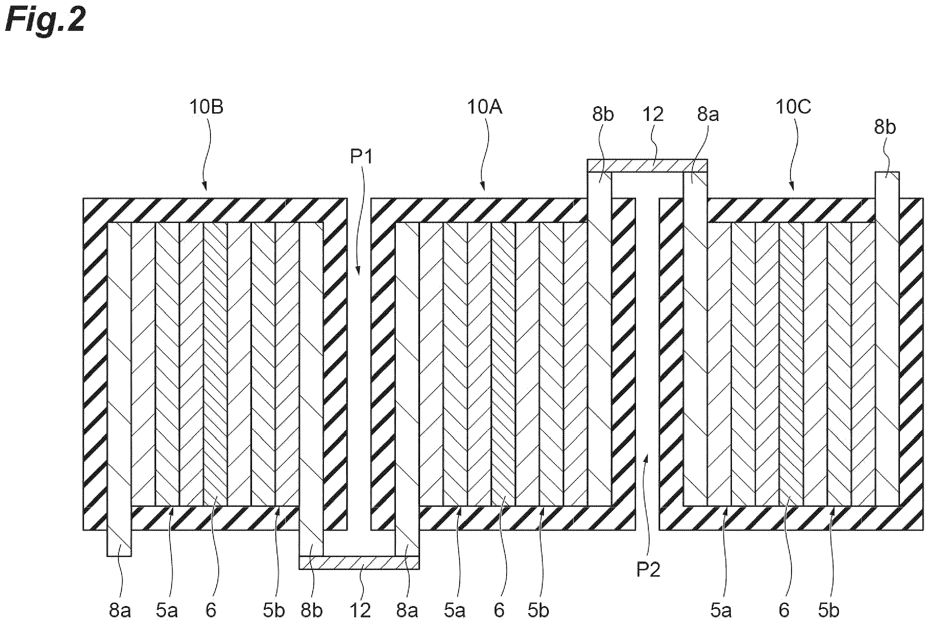

Although the thermoelectric generation device 50 of the first embodiment has been described in detail above, the configuration of the thermoelectric generation device 50 may be changed as follows. For example, the number of heat utilization power generation elements included in each thermoelectric generation module is not limited to two and may be one or may be three or more. Further, the number of thermoelectric generation modules is not limited to three and may be two or may be four or more. Further, the electrical connection of the plurality of thermoelectric generation modules is not limited to a parallel connection and may be a serial connection (see FIG. 2) or may be a combination of a parallel connection and a serial connection. Further, the thermoelectric generation device 50 may include a case in which the housing 9 is accommodated.

### <Second embodiment>

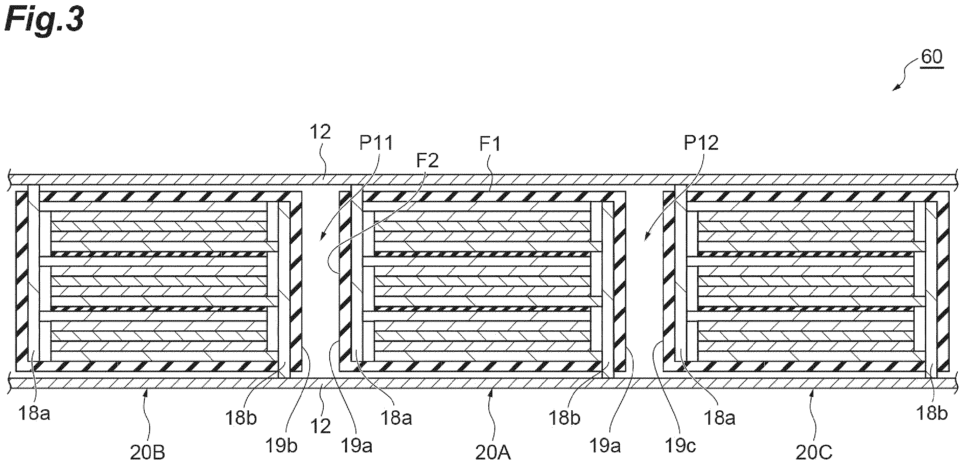

FIG. 3 is a cross-sectional view schematically showing a thermoelectric generation device according to the present embodiment. A thermoelectric generation device 60 shown in FIG. 3 includes three thermoelectric generation modules 20A, 20B, and 20C, which are electrically connected in parallel through the external collector 12. The thermoelectric generation module 20A is disposed between the two thermoelectric generation modules 20B and 20C and is spaced from the thermoelectric generation modules 20B and 20C. Hereinafter, a configuration of the thermoelectric generation module 20A will be described. In the present embodiment, a configuration of each of the thermoelectric generation modules 20B and 20C is the same as that of the thermoelectric generation modules 20A, and thus description thereof will be omitted. Further, in the thermoelectric generation device 60, a configuration different from that of the thermoelectric generation device 50 will be mainly described.

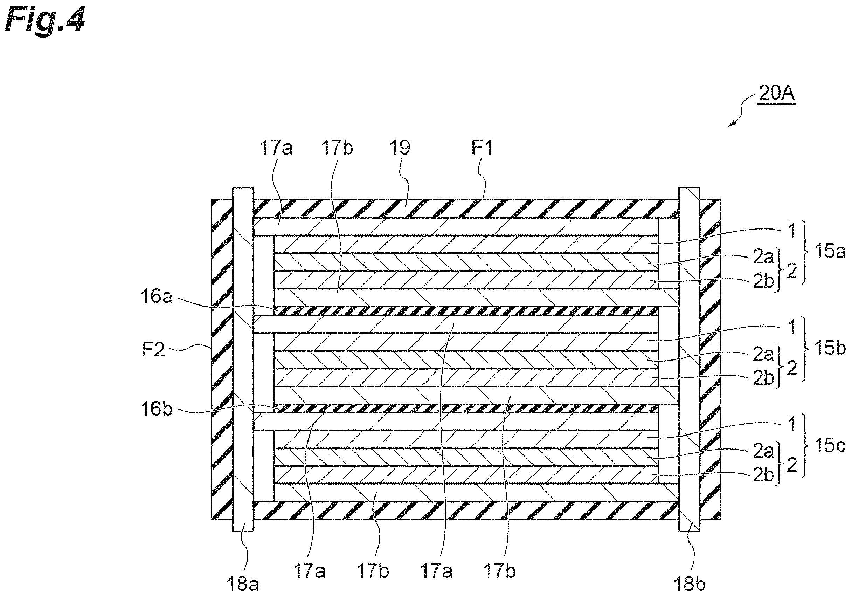

FIG. 4 is a cross-sectional view schematically showing the configuration of the thermoelectric generation module 20A. As shown in FIG. 4, the thermoelectric generation module 20A has three heat utilization power generation elements 15a, 15b, and 15c, two insulating layers 16a and 16b, three pairs of collecting electrodes 17a and 17b, a pair of external electrodes 18a and 18b, and a housing 19 for accommodating them. The three heat utilization power generation elements 15a, 15b, and 15c are stacked to be electrically connected in parallel.

As in the heat utilization power generation element 5a, the heat utilization power generation elements 15a, 15b, and 15c each have the stacked structure including the electrolyte layer 1, the electron thermal excitation layer 2a, and the electron transport layer 2b in that order. The heat utilization power generation elements 15a, 15b, and 15c are each interposed by a pair of collecting electrodes 17a and 17b in the stacking direction. The three collecting electrodes 17a are electrically connected to the external electrode 18a, and the three collecting electrodes 17b are electrically connected to the external electrode 18b.

The insulating layer 16a prevents a short circuit between the heat utilization power generation elements 15a and 15b. The insulating layer 16b prevents a short circuit between the heat utilization power generation elements 15b and 15c. The insulating layer 16a includes, for example, an organic insulating material or inorganic insulating material exhibiting heat resistance. The organic insulating material is, for example, a heat resistant plastic. The inorganic insulating material is, for example, ceramics such as alumina. From a viewpoint of satisfactorily exhibiting performance of the thermoelectric generation module 20A, the insulating layers 16a and 16b may exhibit high thermal conductivity. For example, the thermal conductivity of each of the insulating layers 16a and 16b may be 10 W/m·K or more. Alternatively, the insulating layers 16a and 16b may each contain a member or particle exhibiting excellent heat transfer properties. As long as the member or particle is embedded in the insulating material, the member or particle may be electroconductive.

As described above, the thermoelectric generation module 20A is disposed between the two thermoelectric generation modules 20B and 20C and is spaced from the thermoelectric generation modules 20B and 20C. Since the thermoelectric generation modules 20A, 20B, and 20C is disposed to be spaced from each other, it is possible to form flow paths P11 and P12 between the adjacent thermoelectric generation modules. The flow path P11 is defined by an outer surface 19a of the housing 19 of the thermoelectric generation module 20A and an outer surface 19b of the housing 19 of the thermoelectric generation module 20B. The flow path P12 is defined by an outer surface 19a of the housing 19 of the thermoelectric generation module 20A and an outer surface 19c of the housing 19 of the thermoelectric generation module 20C. The flow paths P11 and P12 extend along a side surface F2 of the thermoelectric generation modules 20A, 20B, and 20C.

By allowing a thermal fluid (for example, a high-temperature gas or liquid) to flow through the flow paths P11 and P12, it is possible to efficiently supply heat to the thermoelectric generation modules 20A, 20B, and 20C. The thermoelectric generation device 60 can efficiently generate high-voltage and/or high-current electricity when applied to a system in which a thermal fluid flows (for example, a heat exchanger, a heat pump, or a cooling pipe). The thermoelectric generation module 20A according to the present embodiment may have a relatively large scale because a rate of heat supply is unlikely to be limited. A power generation output of the thermoelectric generation module 20A may be, for example, 1000 kWh or more, 10 to 1000 kWh, or 0.1 to 10 kWh.

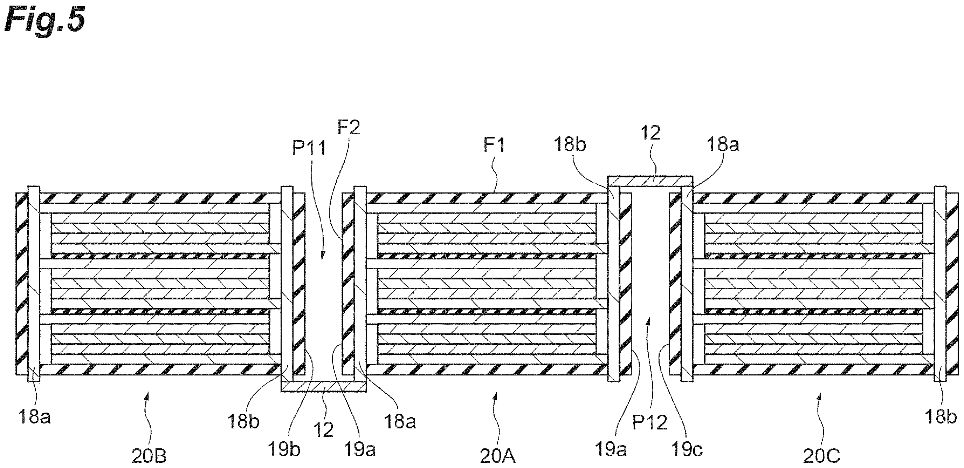

Although the thermoelectric generation device 60 of the second embodiment has been described in detail above, the configuration of the thermoelectric generation device 60 may be changed as follows. For example, the number of heat utilization power generation elements included in each thermoelectric generation module is not limited to three and may be one or two or may be four or more. Further, the number of thermoelectric generation modules is not limited to three and may be two or may be four or more. The electrical connection of the plurality of thermoelectric generation modules is not limited to a parallel connection and may be a serial connection (see FIG. 5) or may be a combination of a parallel connection and a serial connection. For example, in order to fully exert the performance of each thermoelectric generation module even in a case in which a heat source has temperature unevenness, as shown in FIG. 5, the plurality of thermoelectric generation modules each having the same configuration as that of the thermoelectric generation module 20A (a configuration in which a plurality of heat utilization power generation elements are connected in parallel) may be connected in series. Further, the thermoelectric generation device 60 may include a case in which the housing 19 is accommodated.

In the above embodiment, an aspect in which the flow paths P11 and P12 extend along the side surface F2 of the thermoelectric generation modules 20A, 20B and 20C has been illustrated, but in some aspects, the flow paths P11 and P12 may extend along a main surface F1 of the thermoelectric generation modules 20A, 20B and 20C.

### Industrial Applicability

According to the aspect of the present disclosure, a thermoelectric generation device that can sufficiently prevent a rate of heat supply from being limited and is useful for achieving high output is provided.

### Reference Signs List

1 Electrolyte layer
2 Thermoelectric conversion layer
2a Electron thermal excitation layer
2b Electron transport layer
5a, 5b, 15a, 15b, 15c Heat utilization power generation element
6 Electron transmission layer
8a, 8b, 17a, 17b Collecting electrode
18a, 18b External electrode
9, 19 Housing
9a, 9b, 9c Outer surface
10A, 10B, 10C, 20A, 20B, 20C Thermoelectric generation module
12 External collector (electroconductive member)
16a, 16b Insulating layer
50, 60 Thermoelectric generation device
F1 Main surface
F2 Side surface
P1, P2, P3, P11, P12 Flow path

## Claims

1. A thermoelectric generation device comprising:
a first thermoelectric generation module having at least one heat utilization power generation element that includes a stack of an electrolyte layer and a thermoelectric conversion layer and a first housing that accommodates the heat utilization power generation element;
a second thermoelectric generation module having at least one heat utilization power generation element that includes a stack of an electrolyte layer and a thermoelectric conversion layer and a second housing that accommodates the heat utilization power generation element; and
an electroconductive member electrically connecting the first and second thermoelectric generation modules,
wherein the first thermoelectric generation module is spaced from the second thermoelectric generation module.

2. The thermoelectric generation device according to claim 1, comprising a flow path defined by an outer surface of the first housing and an outer surface of the second housing,
wherein a thermal fluid flows through the flow path.

3. The thermoelectric generation device according to claim 2, wherein the flow path extends along a main surface of the thermoelectric generation module.

4. The thermoelectric generation device according to claim 2, wherein the flow path extends along a side surface of the thermoelectric generation module.

5. The thermoelectric generation device according to any one of claims 1 to 4, wherein the first and second thermoelectric generation modules are electrically connected in series.

6. The thermoelectric generation device according to any one of claims 1 to 4, wherein the first and second thermoelectric generation modules are electrically connected in parallel.

7. The thermoelectric generation device according to any one of claims 1 to 6, wherein the first and second thermoelectric generation modules each have a plurality of the heat utilization power generation elements.

8. The thermoelectric generation device according to claim 7, wherein the plurality of heat utilization power generation elements are stacked to be electrically connected in series.

9. The thermoelectric generation device according to claim 8, comprising an electron transmission layer between the adjacent heat utilization power generation elements.

10. The thermoelectric generation device according to claim 7, wherein the plurality of heat utilization power generation elements are stacked to be electrically connected in parallel.

11. The thermoelectric generation device according to claim 10, comprising a collecting electrode electrically connected to the electroconductive member and an insulating layer between the adjacent heat utilization power generation elements.
